# EUROPEAN PATENT SPECIFICATION

(11) **EP 2 225 923 B1**
(45) Date of publication and mention of the grant of the patent: **08.02.2012**
(21) Application number: 07847473.1
(22) Date of filing: 28.11.2007
(51) Int. Cl.: H05K 7/20, H02M 7/00, H01L 31/042

(54) **INVERTER**
UMRICHTER
ONDULEUR

(43) Date of publication of application: 08.09.2010
(73) Proprietor: voltwerk electronics GmbH, 20537 Hamburg (DE)
(72) Inventor: KNAUP, Peter, 64673 Zwingenberg (DE); GONSKA, Gernot, 64807 Dieburg (DE)
(74) Representative: Birken, Lars
(86) International application number: PCT/EP2007/062956
(87) International publication number: WO 2009/068092

(56) References cited:
- EP-A- 0 900 621
- DE-U1- 29 923 011
- DE-U1-202004 005 721
- DE-U1-202004 009 926
- FR-A- 2 886 509
- JP-A- 2003 209 375
- US-A1- 2005 252 638

## Description

### Field of the Invention

The invention relates to an inverter or other electronically controlled power source for transforming electrical energy of predefined voltage and/or current. Further, the invention relates to a method for setting up and operating an inverter or other electronically controlled power source.

### State of the Art

Inverter and other electronically controlled power sources for transforming electrical energy of predefined voltage and/or current are generally known. Such inverters are generally known and used to provide electrical energy of predefined voltage and / or current. To give one example, such inverters are used to transform electrical DC-energy provided by a solar generator into a basically sinusoidal current signal for feeding into a public or private grid. E.g. a 60 Hz signal for the public grid in the United States or a 50 Hz signal for the public European grid.

For transforming the electrical energy at least some power loss within the inverter is unavoidable. In particular such power loss appears at semiconductor switching elements such as IGBTs and also at chokes. To avoid malfunction of the inverter, in particular of the lossy components at which the power loss basically appears, cooling is necessary to avoid exceeding of a certain temperature.

Additionally, the inverter might not only suffer from heat generated by the electronic or electrical components but also by the sun. In particular if the inverter is used in connection with a solar generator, a high level of radiation of the sun is expected. This results in a dilemma for the designer of the inverter, i.e. the inverter could be isolated against heating of the sun but on the other hand ain isolation might also make dissipating of heat more difficult.

However, it is also one general demand for an inverter to be sealed against water and dust and the like to protect the inverter. From the German utility model DE 20 2004 009 926 U1 an inverter is known comprising two chambers. These two chambers are separated by one wall that comprises the lossy components. One chamber comprises a cooling aggregate and each lossy component or a heat sink of it is attached directly to the separating wall and facing the chamber of the cooling aggregate.

However, such a common wall providing the lossy components might conduct heat from a lossy component to its heat sink, but it also conducts heat In the reverse direction, i.e. from the chamber comprising the cooling aggregate to the chamber comprising the other electronic components, which are not considered to be lossy but still may not get too hot. Also, the success of cooling basically depends on the efficiency of the cooling aggregate. Therefore, the success also depends on the energy provided for the cooling aggregate. Such an inverter does also not solve the dilemma of protection of the inverter against the heat of the sun and simultaneously still being able of dissipating heat generated within the inverter.

The Japanese patent application JP 2003209375 A is directed to an electronic appliance case body being constituted of an individual tightly sealed module box 4 individually and tightly sealing electronic components loaded with electronic appliances for respective functions, an electronic unit 1 composed of a water-proof case body 3 having a waterproof/dustproof function and having a water discharge hole 15, where the individual tightly sealed module box 4 is loaded, and an exterior case body 2 shielding the sunlight, to which the appearance design is executed. On the back surface of the waterproof case body 3, a heat sink 11 radiating the heat of the electronic component, a duct 20 for forcibly air-cooling the heat sink 11 and an external waterproof fan 14 are provided.

The French patent application FR 2886509 A is directed to an electronic device operating in difficult environments, The electronic device comprises at least one printed circuit board supporting heat-dissipating electronic components, a heat sink, a first side of which is in contact with electronic components on a first side of the printed circuit board, and a second side of which is designed to evacuate heat by convection, characterized in that it also comprises a cover delimiting a channel in which a coolant circulates to ensure convection, the cover being jointed to the heat sink and the printed circuit board, and in that the channel prevents the coolant from coming into contact with the electric components.

The document US 2005/0252638 A1 is directed to a CPU heat dissipating unit for assembly into a 1 U industrial computer, wherein, used to improve the effect of dissipating heat, mainly consisting of a cover unit, a tunnel unit and a heat disspating fin. The cover unit is assembled to an upper side of a power supply unit, forming a ventilation channel between them. A beat dissipating unit is assembled on an upper side of the CPU and stored suitably into one side of the tunnel unit, while a cooling fan is assembled on the other side, thus providing quick dissipation of heat produced by the CPU.

The German utility model DE 29923011 (s directed to a casing for receiving electrical or electronitcal components. The casing comprises a rear wall, comprising means for conducting heat out of the interior of the casing, wherein the rear wall is formed completely of one plate or of a plurality of forms comprising cooling fins at its outside,

### Object of the invention

Accordingly it is at least one object of the invention to provide an inverter which reduces at least one of the above problems and to provide a method of setting up and/or operating such an inverter. In particular, it is one object of the invention to improve the capabilities of an inverter regarding dissipating of heat and protection against heat. A further object of the present invention is to improve the efficiency of the inverter regarding the dissipating of generated heat and protection against heat from outside.

To achieve these and other objects the invention proposes an inverter or other electronically controlled power source for transforming electrical energy into electrical energy of predetermined voltage and/or current comprising: an inner housing for housing the main circuitry of the inverter, and a cover connected to the inner housing, covering at least part of the inner housing, defining at least one cover channel between the inner housing and the cover for air to flow through that channel for cooling of the inverter, whereby the cover channel is adapted to facilitate natural convection of the air.

Accordingly, the invention proposes an inverter having an inner housing for housing the main circuitry of the inverter. Of course, if another electronically controlled power source is used, the inner housing comprises the main circuitry of that other power source. Such main circuitry usually comprises of one main circuit board having the most or even all electronic components attached, either directly or by means of further smaller circuit boards. Only special parts of the inverter that are necessarily or at least usually located outside might not be housed in the inner housing, such as an operating panel or a display. Also, a choke which is used for filtering our smoothing the generated current or other component dissipating high amount of energy might not be inside this inner housing.

A cover is connected to this inner housing, covering at least part of the inner housing, defining at least one cover channel between the inner housing and the cover. Such cover channel is designed as an air channel for air to flow through this channel to cool the inverter, provided that the air is cooler than the inverter. The channel is provided such, that natural convection of the air is facilitated.

Natural convection of air takes place according to warmer air ascending in an environment of cooler air. The force of such natural convection is, compared to an airflow generated by a fan or a vent, usually weak. The channel to facilitate natural convection must therefore comprise a relatively large cross sectional area. Of course, such channel must be of generally vertical orientation to let the warmer airflow upwards.

The vertical orientation of the channel is provided when the inverter is in use and accordingly, this vertical orientation assumes that the inverter is arranged in a normal upright operational position. Such an upright operational position is usually indicated at the inverter. In particular, any printing or even signs indicate an upright position, including any letters, numbers or signs displayed in a display of the inverter.

According to a further aspect oft the present invention the cover is adapted to protect the inner housing against sunlight, in particular against direct radiation of sunlight. Accordingly, the cover is designed and attached to the inner housing such, that the sunrays do not or only in a very small measure reach the inner housing. I.e. it is only necessary, that the cover basically provides a shade for the inner housing but the cover does not necessarily have to enclose the inner housing completely. However, it must be noted, that the protection against the sun should be provided for a complete day and thus the change of the direction of the sun over the daytime must be taken into account.

According to one embodiment the cover comprises an outside having a light color, in particular white or silver. Such light color enhances the protection of the cover against radiation of sun light. The color can be provided in several ways such as a painting or a coating. In particular when the color is silver, it can be the natural color of a metal such as aluminium forming the cover.

Advantageously, the cover covers at least two sides of the inner housing preferably at least three sides and in particular five of six sides of the inner housing. The number of sides of the housing to be covered depends on many aspects as the shape and size of the inner housing, the shape and size of the cover and also on the intended use and location of use of the inverter. Considering an inner housing having a basically cuboid like shape and thus six sides, at least two, usually three sides would be reached by the sun during a (cloudless) day. These sides should be covered by the cover. In particular, three vertically arranged sides of such inner housing should be covered, also resulting in at least one vertical covered channel. If such cover covering three vertically arranged sides of the inner housing also touches two edges of these three sides, three separately covered channels may result, each corresponding to one side. However, it is preferred that the cover touches the inner housing only as far as necessary for attaching the cover at the inner housing, to avoid any unnecessary heat bridges.

According to one aspect the invention, the cover covers five of six sides of the inner housing i.e. only the back side of the inner housing is not covered by the cover.

A further advantage of such cover is to provide a possibility of an independent appearance. Generally the appearance of the inverter is dependent on the cover rather than the inner housing and any small changes in variations of the inverter might change the appearance of the inner housing, but the cover and thus the appearance of the inverter may remain unchanged.

For protection against the sun, in particular against direct radiation of the sun, the cover would not transmit but reflect the sun. However, at least some heating of the cover when exposed to the sun is expected. The heated cover will as a result heat the air in the cover channel and thus will result in natural convection of the air in the cover channel or it will enhanced it. As a further result there will be an air stream in upward direction, sucking in cooler air at a bottom and this will enhance cooling of the inverter. In other words, heating of the cover by the sun will result in a cooling effect.

According to a further invention a choke or other component dissipating high amount of energy of the inverter is positioned in the cover channel such, that air in the cover channel transports heat from the choke or corresponding component and heat of the choke or corresponding component enhances convection of air in the channel. Accordingly, a choke or corresponding component is positioned outside the inner housing in the cover channel and is exposed to an airflow in this channel. The air will flow along the choke or corresponding component resulting in cooling the choke or corresponding component respectively and heating the air. Since the air gets warmer, natural convection and thus the flow of air in an upward direction is enhanced, improving the cooling of the inverter and the choke or corresponding component. Further embodiments and advantages described for a choke apply also to an other component dissipating high amount of energy.

According to one aspect of the invention the choke or other component dissipating a high amount of energy is positioned at the top or at the bottom of the inner housing and thus is arranged in a top area of the cover channel or a bottom area of the cover channel respectively. If two or more chokes are used, at least one could be arranged in the top area and at least one other could be arranged in the bottom area.

According to one aspect of the invention, the cover channel comprises an input opening for air to enter the cover channel and an output opening for air to exit the cover channel and whereby the input opening is arranged at the bottom of the inverter and the output opening is arranged at the top of the inverter. Such top arrangement and bottom arrangement is to be understood with respect to an inverter being arranged in a normal upright operational position. If a choke is positioned in a bottom area, this would preferably be close to the input opening and if a choke is arranged in the top area this could preferably be close to the output opening. If a choke is arranged close to the input opening, it will be subjected to cool air entering the cover channel resulting in a good cooling result of the choke. On the other hand, if the choke is arranged close to the output opening the air heated by the choke will subsequently exit the cover channel and thus cannot heat the inverter.

According to a further aspect the inverter comprises at least one heat sink for cooling power components of the inverter, whereby the heat sink is attached to the inner housing basically providing a space between the heat sink and the inner housing.

Such a heat sink usually consists of a base with one or more flat surfaces and an array of comb or fin-like protrusions to increase the heat sink's surface area contacting the air. Contrary to known systems the base does not provide one wall of the inner housing nor is the base and in particular such a flat surface directly connected to a wall having a large contact area. Instead, the invention proposes to leave a space such as a gap between the heat sink and the inner housing, in particular between the base or base plate of the heat sink and a wall of the inner housing. This way, it is avoided that heat in the heat sink is conducted back to such wall of the inner housing and thus back to the inner housing. Accordingly this avoids any reversely directed flow of heat back into the housing. This aspect shall improve the cooling properties of the inverter with respect to the heat sink. This aspect may improve the heating properties of an inverter independently to the aspect of providing a cover to further provide a cover channel. However, both of these general features may be combined having synergetic effects.

According to one aspect of the invention the inner housing is sealed against the environment to prevent the circuitry of the inverter against dust and/or water. This way, a good protection can protect the circuitry of the inverter by means of a sealed inner housing, whereby good cooling properties can still be achieved.

According to a further embodiment power components which need external cooling, e.g. semiconductor switches such as IGBTs, or other components dissipating a high amount of energy extend through the casing of the inner housing against the heat sink and/or are sealed against the inner housing. Accordingly, such power components may be attached to the same circuit board as all other components which do not need cooling. But these power components extend through the casing of the inner housing, in particular through a wall of inner housing, extend through the space or gap between the inner housing and the heat sink and finally are attached against the heat sink e.g. at a base or base plate of it. This way the power components are mounted at the heat sink for conducting heat generated in the power components to the heat sink but the inner housing remains sealed and a distance between the inner housing and the heat sink does also remain.

Advantageously the heat sink comprises a base plate having one or a plurality of power components attached to that base plate, whereby the base plate comprises protrusions extending towards the power components so as to provide a base for each attached power component. Such protrusion can extend at least partly through a gap or space between the base plate and the inner housing. This way even flat components electrically connected within the inner housing can be attached to the base plate and a gap or space can still be provided between the base plate and the inner housing. According to one embodiment, at least one of such protrusions can extend through the gap or space into the housing for being attached to a component that needs cooling, whereby the protrusion is sealed against the wall of the inner housing. Therefore, the protrusion can conduct heat of that component to the base plate of the heat sink, whereas conducting heat from the base plate back to the inner housing is avoided due to the gap or space between the base plate.

As proposed according to one aspect the heat sink may be attached to the inner housing by means of distance pieces. E.g. the heat sink might be screwed at four corners of the heat sink through such distance pieces and into the inner housing. Such distance pieces might be provided as cylinders of a material that does not conduct heat very well, such as a plastic material, or a ceramic material or resin or such alike. The distance pieces may also take the form of two bars holding the heat sink at two sides.

It is also to be noted, that at least one main circuit board in the inner housing does not necessarily need to be attached to a wall of the inner housing facing towards the heat sink, but there might also be provided a gap between such circuit board and the wall of the inner housing, to have a further distance providing a further heat protection of the circuit board.

In a further embodiment the inverter comprises a heat sink channel accommodating the heat sink for guiding air long the heat sink for cooling this way, providing an air stream along the heat sink is facilitated. If the heat sink comprises a plurality of fin-like protrusions, the heat sink channel is oriented in the same direction as the fin-like protrusions are.

According to one embodiment an airflow along the heat sink is enhanced by means of at least one vent for blowing air through the heat sink channel along the heat sink and in particular also through the space or gap between the inner housing and the heat sink. This way, the heat sink channel ensures a certain direction of an airflow whereas the vent provides for or increases the velocity of such air stream. As the heat sink is basically not attached with the large surface of a base of it to the inner housing, this surface of the base can also be used for dissipating heat by means of an air stream. Therefore, the vent not only blows the air along the finlike protrusions but also along such surface facing the inner housing and thus facing the space or gap between them.

According to a further aspect it is proposed to provide the output opening of the cover channel adjacent to an output opening of the heat sink channel. This way, the hot air coming out of both output openings may be directed in the same direction. Even though the cover channel and the heat sink channel are basically independent of each other the arrangement of both openings next to each other might result in a suction effect from the one channel to the other one. In particular, if the heat sink channel is provided with at least one a vent whereas the cover channel is not provided with a vent the air of the heat sink channel might flow with a higher velocity and thus the cover channel might be subjected to a suction effect resulting from the higher velocity of the heat sink channel.

The invention also provides for a method for setting up and operating an inverter or other electronically controlled power source for transforming electrical energy into electrical energy of predetermined voltage and/or current, having an inner housing for housing the main circuitry of the inverter and a cover, covering at least part of the inner housing, defining at least one cover channel between the inner housing and the cover comprising the steps:
- attaching the inverter on an object such as a wall to hold the inverter and
- arranging the cover channel in a basically vertical manner, such that an input opening for air to enter the channel is basically arranged at the bottom of the channel and an output opening for air to exit the channel is basically arranged at the top of the channel.

Additionally, the method comprises the step:
- positioning the inverter such, that the cover basically faces the direction to the sun at day time such, that the cover at least partly protects the inner housing of the inverter against radiation of the sun at day time.

Accordingly, one step is to arrange the inverter in a fixed position and thus in an upright position. For protection against radiation of the sun the inverter is positioned such, that the cover basically faces the direction to the sun at daytime, taking into account, that the direction of the sun will change of approximately 180° during the daytime. The term "facing the direction of the sun" basically refers to a direction in the horizontal plane, and is not meant to refer to an inclination. As a result of providing an upright position of the inverter the cover channel should also be arranged in a basically vertical manner. The operating of the inverter with respect to transforming the electrical energy into electrical energy of predefined voltage and/or current is performed as generally known. However, it should be taken care, that any openings of the cover channel and/or the heat sink channel are kept open to prevent the air to flow in the corresponding channel and out of the corresponding channel.

Of course, the inverter might be installed in a location where it is not or only partly subjected to radiation of the sun. This can be in a shaded place or an inside place.

According to one aspect a solar system is proposed for providing electrical energy of predefined voltage and/or current comprising at least one solar generator outputting electrical energy as a DC-signal and at least one inverter according to at least on aspect of the present invention for transforming the DC-signal of the solar generator into an AC-signal of predefined frequency for feeding into an isolated grid or a public grid. A solar generator, comprising of one or a plurality of photovoltaic cells is usually installed in an area of increased sun radiation and thus an inverter coupled to this solar generator is also subjected to this increased sun radiation. To avoid overheating of the inverter, such solar system is provided with an inventive inverter, in particular an inverter comprising a cover to protect the inverter against sun radiation. Such solar systems, in particular if they are of large size, are provided in rural areas or even deserts. Such solar systems are more likely to be exposed to dust or other influences of the environment such as water. The reliability of such systems may be improved by using an inverter having good cooling properties including good properties for protection against the sun, whereas at the same time at least the main part of the inverter is effectively sealed against dust and water and such alike.

### Brief Description of the Figures

Preferred embodiments of the invention are described with reference to the accompanying figures, wherein
- Fig. 1: shows a perspective view of a first embodiment of an inverter according to the invention,
- Fig. 2: shows a front view of the embodiment according to figure 1,
- Fig. 3: shows a back view of the embodiment of figure 1,
- Fig. 4: is a cross sectional view of the embodiment of figure 3 according to the arrows A-A of figure 3,
- Fig. 5: shows a cross sectional view of the embodiment of figure 3 according to the arrows B-B of figure 3, in greater detail and
- Fig. 6: shows a bottom plan view of the embodiment of figures 1-5.

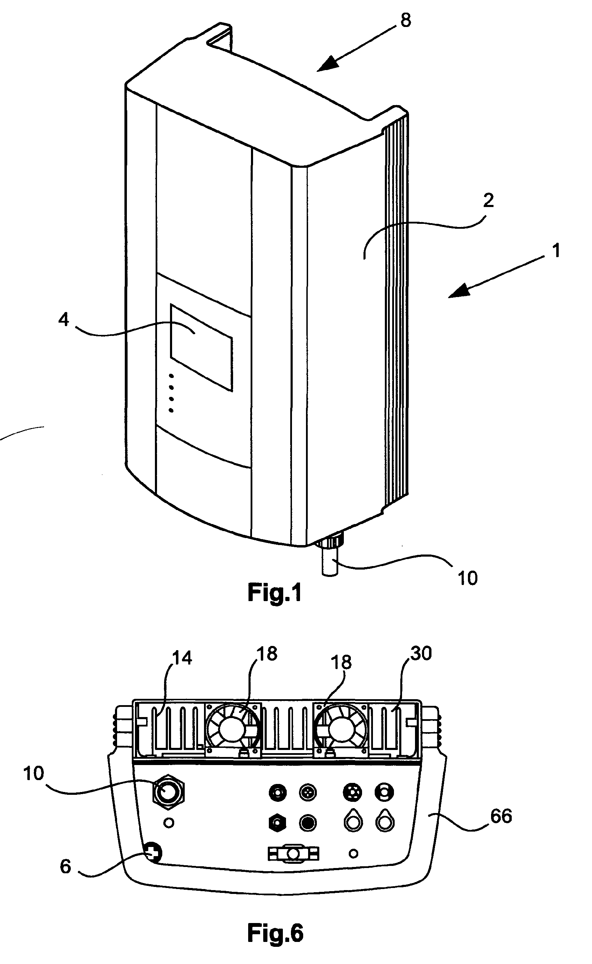

Figure 1 shows an inverter 1 having a cover 2. And according to the perspective of figure 1 the cover 2 basically completely covers the inverter 1, as the perspective according to figure 1 equals one possible direction of the sun radiation. Attached to the cover 2 is a display 4 for displaying inverter related information. At the bottom of the inverter 1 there is also shown a drainage adapter 6. At the top and back edge of the inverter 1 there is indicated a common opening 8 for air to exit the inverter 1.

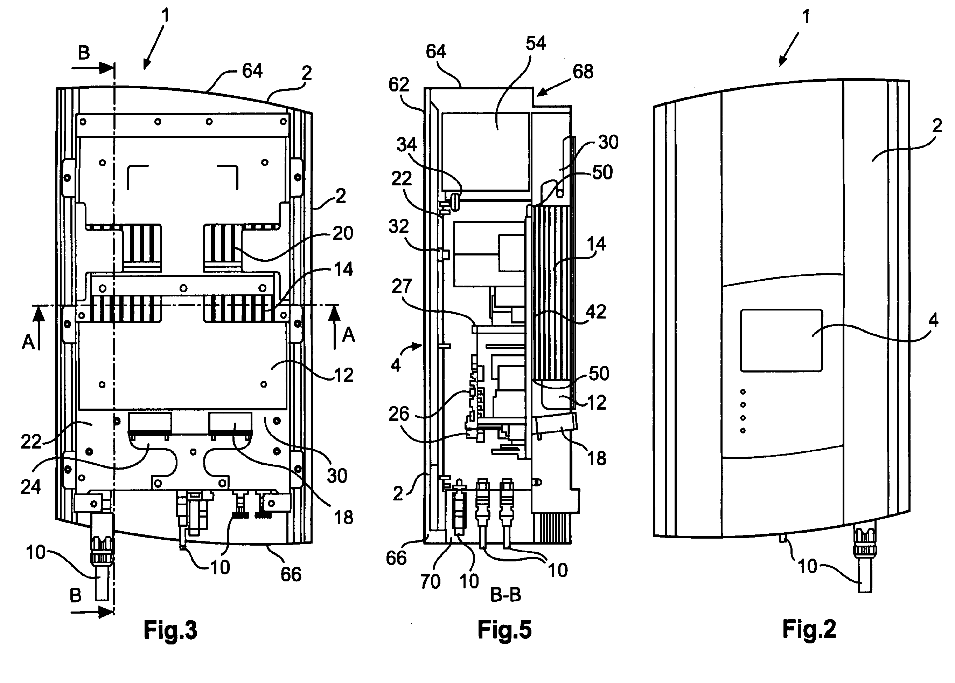

Figure 2 also shows the cover 2, display 4 and the drainage adapter 6 of the inverter 1. In that front view a connector 10 is also indicated at the bottom side of the inverter 1.

According to the back view of figure 3 only part of the cover 2 can be seen basically at both sides and at the top and the bottom of the inverter 1. Attached to the inverter 1 at its backside is a cover plate 12 partly covering a heat sink 14 and thus forming a heat sink channel 30 of a basically open configuration. It is to be noted, that the cover plate 12 covering the heat sink does not form part of the cover 2 for forming a cover channel. To blow air in an upward direction, two vents 18 are positioned below the heat sink 14 and will, when in operation, blow air to the heat sink 14 and along the fin-like structure 20 of the heat sink.

Figure 3 also shows in its bottom area a part of the back side of the inner housing 22. Attached to this inner housing are the vents 18 using an attachment means 24. The back view according to figure 3 shows further connectors 10 or connecting adapters for electrically connecting the inverter 1.

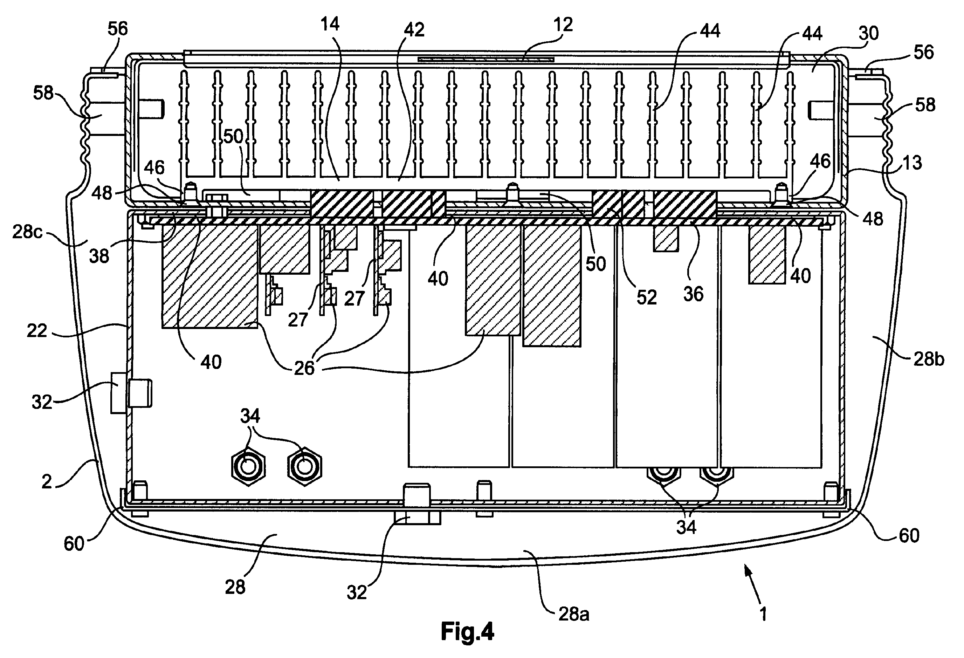

Figure 4 shows a cross sectional view from a bottom perspective according to an intersection indicated by arrows A-A in figure 3. This view illustrates the subdivision of the inverter 1. Accordingly, the inverter 1 consists basically of an inner housing 22 enclosing electronic components, a cover channel 28 defined between the cover 2 and the inner housing 22 and a heat sink area or heat sink channel 30 basically defined between the inner housing 22 and a heat sink plate 12 and/or a device such as a wall to which the inverter 1 is attached.

The inner housing 22 is sealed against the environment and a pressure compensation adapter 32 is provided to fulfil a pressure equalisation if necessary. Accordingly, all electrical connections 10 (cf. figure 3 and figure 5) as well as connections 34 for proving a connection to chokes positioned on top of the inner housing 22 are adapted to ensure the sealed state of the inner housing 22.

The electronic components 26 are basically arranged on a main circuit board 36, that is arranged in a plane parallel to a back wall 38 of the inner housing 22 but comprising a gap 40 between the main circuit board 36 at the back wall 38. Many of the components 26 do not produce considerable heat and are arranged at the main circuit board 36 facing to the inside of the inner housing 22. Some of these components 26 are arranged on smaller circuit boards 27, which are attached or connected to the main circuit board 36. It is to be noted, that the electronic components 26, including the smaller circuit boards 27 are only shown in a schematic way and the components, the number of the components, the certain arrangement and so on may vary with respect to different inverters. However, the used electronic components and thus any possible variations are not of importance for the present invention.

The heat sink channel 30 is basically defined by the heat sink plate 12 and/or a device such as a wall to which the inverter 1 is attached and a support frame 13. The support frame 13 is attached to the inner housing 22 at the back wall 38 and does support the heat sink 14. The heat sink 14 comprises one base plate 42 and a plurality of fin-like means 44 for enlarging the surface of the heat sink 14. At the base plate 42 there are provided protrusions 46, on which the heat sink 14 is attached to the support frame 13 by means of screws 48.

The protrusions 46 function as distance pieces integrally formed with the heat sink 14, to provide a gap 50 between the base plate 42 of the heat sink 14 and the support frame 13. Accordingly, a gap 50 is provided between the heat sink 14 and the inner housing 22. According to an other embodiment, there are further fin-like means at the base plate protruding into the gap, to further increase the surface of the heat sink.

According to figure 4, some power components 52, that need cooling during operation of the inverter 1 are mounted at the main circuit board 36, but face into the direction of the heat sink 14. These power components 52 extend through the back wall 38 of the inner housing 22 to the base plate 42 of the heat sink 14. These power components 52 are sealed against the back wall 38 of the inner housing 22. The power components are with one side attached to the base plate 42 of the heat sink 14 such, that good heat conduction from the power components 52 to the heat sink 14 is provided. Accordingly, any heat conducting connection between the inner housing and the heat sink 14 is only provided by means of the power components 52 themselves. Such heat conducting connection is necessary but any other heat conduction connections between the inner housing and the heat sink are avoided. The gap 50 between the base plate 42 of the heat sink 14 and the back wall 38 of the inner housing 22 also provides for an air channel so air can flow through this gap and provide further cooling for the heat sink as well as for the back wall 38 and thus for the inner housing 22.

A cover 2 is at two sides attached to the support frame 13 at attachment lash 56 further involving support means 58. Because the cover 2 almost touches edges 60 of the inner housing 22, the cover channel 28 is basically subdivided in a front and two side cover channels 28 a-c. A cover channel 28 and also the sub channels 28a-c according to figure 4 provide a relatively large cross sectional area. Accordingly, there is no strong flow resistance hindering an upward air stream and thus the cover channel 28 and the sub channels 28 a-c provide for natural convection of air.

The cross sectional view according to figure 5 provides basically a side perspective of the inverter 1. Accordingly, the vent 18 is arranged below the heat sink 14 and adapted to provide an air stream having an upwards direction to flow along the heat sink 14. Figure 5 also shows a slightly inclined position of the vent 18 and accordingly the vent 18 ensures to also blow air into the gap 50 between the inner housing 22 and the base plate 42 of the heat sink.

Figure 5 more clearly shows some components of the inner housing 22, i.e. the drainage adapter 6, connectors 10 and electronic components 26 and smaller circuit boards 27. Above the inner housing 22 a choke 54 is positioned and connected via the connection 34 to the inner housing.

The cover 2, as seen in figure 5 comprises a front cover 62, a top cover 64 and a bottom skirt 66. The top cover 64 completely covers the upper side of the inner housing 22 and the chokes 54 arranged above the inner housing 22 at the top side. The cover 2 further provides a top opening 68 of the cover channel 28. The air flowing upwards in the cover channel 28 will thus exit the cover channel 28 at the top opening 68. It can also be seen, that the choke 54 is basically positioned in the cover channel 28 at one side of it. The top opening 68 thus basically faces in a backwards direction.

A bottom opening 70 for air to enter the cover channel 28 is basically positioned next to the bottoms skirt 66, facing in a downward direction.

Figure 6 illustrates the shape of the skirt 66, basically forming a stripe like form according to the bottom view of this figure. This figure also shows the drainage adapter 6, connectors 10, vents 18 and a heat sink 14 that is partly provided in a heat sink channel 30.

When operating the inverter 1 air in the cover channel 28 will be heated in particular by means of the chokes 54 and by means of the cover 2 when being heated by the sun. Accordingly, the heated air will flow upwards according to natural convection and as a result cooler air from the outside will flow into the bottom opening 70 and thus cool the inner housing 22 and the cover 2 of the inverter, while gradually being heated in the cover channel. The heated air flowing upwards will exit the cover channel 28 at the top opening 68. For cooling the power components and thus cooling the heat sink 14, the vents 18 will blow air along the heat sinks 14, in particular along the fin-like means 44 and through the gap 50 along the base plate 42. This air will be heated by the heat sink and will be flowing in the heat sink channel. This hot air will exit the heat sink channel 30 in an area close to the top opening 68 of the cover channel 28. In this area, the air of the cover channel 28 and the air of the heat sink channel 30 will come together. Because of the vents 18 the air in the heat sink channel usually has a larger velocity than the air in the cover channel 2, the air exiting the heat sink channel 30 might provide a suction effect on the air in the cover channel 22 and thus might accelerate the air flow in the cover channel 28.

## Claims

1. Inverter (1) or other electronically controlled power source for transforming electrical energy into electrical energy of predetermined voltage and/or current comprising::
an inner housing (22) for housing the main circuitry of the inverter (1), and a cover (2) connected to the inner housing (22), covering at least part of the inner housing (22), defining at least one cover channel (28) between the inner hosing (22) and the cover (2) for air to flow through that channel for cooling of the inverter (1), whereby the cover channel (28) is adapted to facilitate natural convection of the air, **characterized in that** at least one choke (54) or other component dissipating a high amount of energy is positioned in the channel (28) such that air In the cover channels (28) transports heat from that choke (54) or other component and heat of that choke (54) or other component enhances convection of air in the channel (28).

2. Inverter (1) according to claim 9, whereby the cover channel (28) is adapted to facilitate a vertically directed convection of air, when the inverter (1) is arranged in a normal up right operational position.

3. Inverter (1) according to claim 1 or 2. whereby the cover channel (28) has a basically vertical orientation, when the inverter (1) is arranged in a normal up right operational position.

4. Inverter (1) according to any of claims 1 to 3, whereby the cover is adapted, to protect the inner housing (22) against sun light, in particular against direct radiation of sun light

5. Inverter (1) according to any of the preceding claims, whereby the cover (2) comprises an outside having a light color, in particular white or silver,

6. Inverter (1) according to any of the preceding claims, whereby the cover (2) covers at least two sides of the inner housing (22), preferably at least three sides and in particular five of six sides of the inner housing (22).

7. Inverter (1) according to claim 6, whereby the or a choke (54) or other component dissipating a high amount of energy is positioned at the top and/or the bottom of the inner housing (22).

8. Inverter (1) according to any of the preceding claims, whereby the cover channel (28) comprises an input opening for air to enter the cover channel (28) and an output opening for air to exit the cover channel (28) and whereby the input opening is arranged at the bottom of the inverter and the output opening is arranged at the top of the inverter (1), when the inverter (1) is arranged in a normal up right operational position,

9. Inverter (1) according to any of the preceding claims, comprising:
at least one heat sink for cooling power components of the inverter,
whereby the heat sink (14) is attached to the inner housing (22), basically providing a space between the heat sink (14) and the inner housing (22).

10. Method for setting up and operating an inverter (1) or other electronically controlled power source for transforming electrical energy into electriCal energy of predetermined voltage and/or current, having an inner housing (22) for housing the main circuitry of the inverter (1) and a cover (2), covering at least part of the inner housing (22), defining at least one cover channel (28) between the inner housing (22) and the cover (2) comprising the steps:
- zttaching the inverter (1) on an object such as a wall to hold the Inverter (1), and
- arranging the cover channel (28) in a basically vertical manner, such that an input opening for air to enter the channel (28) Is basically arranged at the bottom of the channel (28) and an output opening for air to exit the channel is basically arranged at the top of the channel (28),
**characterized in that** natural convection of air in the cover channel (28) is enhanced by means of heat of at least one choke (54) or other component dissipating a high amount of energy arranged in or at the cover channel (28).

11. Method according to claim 10, further comprising the step
- positioning the inverter (1) such, that the cover (2) basically faces the direction to the sun at day time such, that the cover (2) at least partly protects the inner housing (22) of the inverter (1) against radiation of the sun at day time.

12. Method according to claim 10 or 11, whereby at least one vent (18) is drive to blow air along a or the heat sink (14) of the inverter (1) and a flow of air is provided in the cover channel (28) by means of natural convection.

13. Solar system for providing electrical energy of predefined voltage and/or current comprising at least one solar generator outputting electrical energy as a DC-signal, and at least one inverter (1) according to any of the claims 1 to 9 for transforming the DC-signal of the solar generator into an AC-signal of predefined frequency for feeding into a private grid or public grid.

## Patentansprüche

1. Inverter (1) oder andere elektronisch gesteuerte Leistungsquelle zum Transformieren von elektrischer Energie in elektrische Energie vorgegebener Spannung und/oder Stromstärke umfassend:
e in Innengehäuse (22) zum Aufnehmen der Hauptschaltung des Inverters (1) und eine mit dem Innengehäuse (22) verbundene Abdeckung, welche zumindest einen Teil des Innengehäuses (22) abdeckt, der zumindest einen Abdeckkanal (28) zwischen dem Innengehäuse (22) und der Abdeckung (2) definiert, damit Luft durch den Kanal zum Kühlen des Inverters (1) fließt, wobei der Abdeckkanal (28) geeignet ist, um eine natürliche Luftkonvektion zu fördern, **dadurch gekennzeichnet, dass** zumindest eine Drossel (54) oder andere Komponente, die eine große Energiemenge abführt, in dem Kanal (28) derart positioniert ist, dass Luft in dem Abdeckkanal (28) Wärme von der Drossel (54) oder einer anderen Komponente transportiert und Wärme dieser Drossel (54) oder einer anderen Komponente die Luftkonvektion in dem Kanal (28) verbessert

2. Inverter (1) nach Anspruch 1, wobei der Abdeckkanal (28) geeignet ist, um eine vertikal gerichtete Luftkonvektion zu fördern, wenn der Inverter (1) in einer normalen aufrechten betriebsbereiten Position angeordnet ist.

3. Inverter (1) nach Anspruch 1 oder 2, wobei der Abdeckkanal (28) eine im Wesentlichen vertikale Orientierung aufweist, wenn der Inverter (1) in einer normalen aufrechten betriebsbereiten Position angeordnet ist.

4. Inverter (1) nach einem der Ansprüche 1 bis 3, wobei die Abdeckung geeignet ist, um das Innengehäuse (22) gegen Sonnenlicht, insbesondere gegen direkte Einstrahlung von Sonnenlicht, zu schützen.

5. Inverter (1) nach einem der vorstehenden Ansprüche, wobei die Abdekkung (2) ein Äußeres umfasst, welches eine Lichtfarbe aufweist, insbesondere Weiß oder Silber.

6. Inverter (1) nach einem der vorstehenden Ansprüche, wobei die Abdekkung (2) zumindest zwei Seiten des Innengehäuses (22), bevorzugt zumindest drei Seiten und insbesondere fünf von sechs Seiten des Innengehäuses (22), abdeckt.

7. Inverter (1) nach Anspruch 6, wobei die oder eine Drossel (45) oder eine andere Komponente, welche eine große Energiemenge abführt, an dem oberen Bereich und/oder dem Boden des Innengehäuses (22) positioniert ist.

8. Inverter (1) nach einem der vorstehenden Ansprüche, wobei der Abdeckkanal (28) eine Eingangsöffnung für Luft zum Eintreten in den Abdeckkanal (28) und eine Ausgangsöffnung für Luft zum Austreten aus dem Abdeckkanal (28) umfasst und wobei die Eingangsöffnung an dem Boden des Inverters angeordnet ist und die Ausgangsöffnung an dem oberen Bereich des Inverters (1) angeordnet ist, wenn der Inverter (1) in einer normalen aufrechten betriebsbereiten Position angeordnet ist.

9. Inverter (1) nach einem der vorstehenden Ansprüche, umfassend:
zumindest eine Wärmesenke zum Kühlen von Leistungskomponenten des Inverters,
wobei die Wärmesenke (14) an dem Innengehäuse (22) befestigt ist, welches im Wesentlichen einen Raum zwischen der Wärmesenke (14) und dem Innengehäuse (22) bereitstellt.

10. Verfahren zum Aufstellen und Betreiben eines Inverters (1) oder einer anderen elektronisch gesteuerten Leistungsquelle zum Transformieren elektrischer Energie in elektrische Energie vorgegebener Spannung und/oder Stromstärke, aufweisend ein Innengehäuse (22) zum Aufnehmen der Hauptschaltung des Inverters (1) und eine Abdeckung (2), welche zumindest einen Teil des Innengehäuses (22) abdeckt, der zumindest einen Abdeckkanal (28) zwischen dem Innengehäuse (22) und der Abdeckung (2) definiert umfassend die Schritte:
- Befestigen des Inverters (1) an einem Objekt wie beispielsweise einer Wandung zum Halten des Inverters (1) und
- Anordnen des Abdeckkanals (28) in einer im Wesentlichen vertikalen Weise derart, dass eine Eingangsöffnung für Luft zum Eintreten in den Kanal (28) im Wesentlichen an dem Boden des Kanals (28) angeordnet ist und eine Ausgangsöffnung für Luft zum Austreten aus dem Kanal im Wesentlichen an dem oberen Bereich des Kanals (28) angeordnet ist,
**dadurch gekennzeichnet, dass** natürliche Luftkonvektion in dem Abdeckkanal (28) mittels Wärme zumindest einer Drossel (54) oder einer anderen Komponente, die eine große Energiemenge abführt, verbessert wird, welche in oder an dem Abdeckkanal (28) angeordnet ist.

11. Verfahren nach Anspruch 10, weiter umfassend den Schritt
- Positionieren des Inverters (1) derart, dass die Abdeckung (2) im Wesentlichen derart in Richtung Sonne während des Tages ausgerichtet ist, dass die Abdeckung (2) zumindest teilweise das Innengehäuse (22) des Inverters (1) gegen Einstrahlung der Sonne während des Tages schützt.

12. Verfahren nach Anspruch 10 oder 11, bei dem zumindest ein Lüfter (18) angetrieben wird, um Luft entlang einer oder der Wärmesenke (14) des Inverters (1) zu blasen, und bei dem ein Luftfluss in dem Abdeckkanal (18) mittels natürlicher Konvektion bereitgestellt wird.

13. Solarsystem zum Bereitstellen elektrischer Energie einer vorgegebenen Spannung und/oder Stromstärke umfassend zumindest einen Solargenerator, welcher elektrische Energie als DC-Signal ausgibt, und zumindest einen Inverter (1) nach einem der Ansprüche 1 bis 9 zum Transformieren des DC-Signals des Solargenerators in ein AC-Signal vorgegebener Frequenz zum Einspeisen in ein privates oder öffentliches Netz.

## Revendications

1. Onduleur (1) ou autre source d'alimentation commandée électroniquement pour transformer l'énergie électrique en énergie électrique de tension et/ou de courant prédéterminé comprenant :
u n boîtier interne (22) pour loger le circuit principal de l'onduleur (1), et un couvercle (2) raccordé au boîtier interne (22), couvrant au moins une partie du boîtier interne (22), définissant au moins un canal de couvercle (28) entre le boîtier interne (22) et le couvercle (2) pour que l'air passe à travers ce canal pour le refroidissement de l'onduleur (1), dans lequel le canal de couvercle (28) est adapté pour faciliter la convection naturelle de l'air, **caractérisé en ce qu'**au moins un dispositif à piège (54) ou un autre composant dissipant une quantité élevée d'énergie est positionné dans le canal (28) de telle sorte que l'air dans le canal de couvercle (28) transporte la chaleur de ce dispositif à piège (54) ou autre composant et la chaleur de ce dispositif à piège (54) ou autre composant améliore la convection de l'air dans le canal (28).

2. Onduleur (1) selon la revendication 1, dans lequel le canal de couvercle (28) est adapté pour faciliter une convection dirigée verticalement de l'air, lorsque l'onduleux (1) est disposé dans une position opérationnelle debout normale.

3. Onduleur (1) selon la revendication 1 ou 2, dans lequel le canal de couvercle (28) a une autre orientation fondamentalement verticale, lorsque l'onduleur (1) est disposé dans une position opérationnelle debout normale.

4. Onduleur (1) selon l'une quelconque des revendications 1 à 3, dans lequel le couvercle est adapté pour protéger le boîtier interne (22) contre la lumière du soleil, en particulier contre la radiation directe de la lumière du soleil.

5. Onduleur (1) selon l'une quelconque des revendications précédentes, dans lequel le couvercle (2) comprend un extérieur ayant une couleur claire, en particulier blanche ou argent.

6. Onduleur (1) selon l'une quelconque des revendications précédentes, dans lequel le couvercle (2) couvre au moins deux côtés du boîtier interne (22), préférablement au moins trois côtés et en particulier cinq de six côtés du boîtier interne (22).

7. Onduleur (1) selon la revendication 6, dans lequel soit un dispositif à piège (54) soit un autre composant dissipant une quantité élevée d'énergie est positionné en haut et/ou en bas du boîtier interne (22).

8. Onduleur (1) selon l'une quelconque des revendications précédentes, dans lequel le canal de couvercle (28) comprend une ouverture d'entrée pour que l'air pénètre dans le canal de couvercle (28) et une ouverture de sortie pour que l'air sorte du canal de couvercle (28) et dans lequel l'ouverture d'entrée est disposée au bas de l'onduleur et l'ouverture de sortie est disposée en haut de l'onduleur (1), lorsque l'onduleur (1) est disposé dans une position opérationnelle debout normale.

9. Onduleur (1) selon l'une quelconque des revendications précédentes, comprenant :
au moins un dissipateur thermique pour refroidir des composants de puissance de l'onduleur,
dans lequel le dissipateur thermique (14) est attaché au boîtier interne (22), fournissant fondamentalement un espace entre le dissipateur thermique (14) et le boîtier interne (22).

10. Procédé pour régler et exploiter un onduleur (1) ou une autre source d'alimentation commandée électroniquement pour la transformation de l'énergie électrique en une énergie électrique de tension et/ou courant prédéterminé, ayant un boîtier interne (22) pour loger le circuit principal de l'onduleur (1) et un couvercle (2), couvrant au moins une partie du boîtier interne (22) définissant au moins un canal de couvercle (28) entre le boîtier interne (22) et le couvercle (2) comprenant les étapes de :
- fixation de l'onduleur (1) sur un objet telle qu'une paroi pour maintenir l'onduleur (1), et
- disposition du canal de couvercle (28) d'une manière fondamentalement verticale de sorte qu'une ouverture d'entrée pour que l'air dans pénètre le canal (28) est fondamentalement disposée au bas du canal (28) et une ouverture de sortie pour que l'air sorte du canal est fondamentalement disposée en haut du canal (28),
**caractérisé en ce que** la convection naturelle de l'air dans le canal de couvercle (28) est améliorée au moyen de la chaleur d'au moins un dispositif à piège (54) ou un autre composant dissipant une quantité élevée d'énergie disposée dans ou sur le canal de couvercle (28).

11. Procédé selon la revendication 10, comprenant les étapes de
- positionnement de l'onduleur (1) pour que, le couvercle (2) soit en regard fondamentalement de la direction du soleil durant la journée afin que, le couvercle (2) protège au moins partiellement le boîtier interne (22) de l'onduleur (1) contre la radiation du soleil dans la journée.

12. Procédé selon la revendication 10 ou 11, dans lequel au moins un évent (18) est commandé pour souffler l'air le long du dissipateur thermique (14) de l'onduleur (1) et un flux d'air est fourni dans le canal de couvercle (28) au moyen d'une convection naturelle.

13. Système solaire pour fournir une énergie électrique de tension et/ou un courant prédéfini comprenant au moins un générateur solaire fournissant l'énergie électrique comme un signal continu, et au moins un onduleur (1) selon l'une quelconque des revendications 1 à 9 pour transformer le signal continu du générateur solaire en un signal alternatif de fréquence prédéfinie pour l'alimentation dans un réseau privé ou un réseau public.
